# EUROPÄISCHE PATENTANMELDUNG

(11) **EP 2 492 959 A1**
(43) Veröffentlichungstag der Anmeldung: **29.08.2012**
(21) Anmeldenummer: 12154832.5
(22) Anmeldetag: 10.02.2012
(51) Int. Cl.: H01L 23/498, H01L 21/56, H01L 21/60

(54) **Elektrisches Bauelement mit einer elektrischen Verbindungsanordnung und Verfahren zu dessen Herstellung**

(30) Priorität: 22.02.2011 DE 102011000866; 22.02.2011 US 201161445055 P
(71) Anmelder: Micro Systems Engineering GmbH, 95180 Berg (DE)
(72) Erfinder: Dohle, Rainer, 01723 Kesseldorf (DE); Schüßler, Florian, 91054 Erlangen (DE); Diehm, Rolf, 97877 Wertheim (DE); Keßling, Oliver, 84034 Landshut (DE); Oppert, Thomas, 14089 Berlin (DE)
(74) Vertreter: Lindner-Vogt, Karin L.

(57) **Zusammenfassung**

Die Erfindung betrifft ein elektrisches Bauteil sowie ein Verfahren zu dessen Herstellung, mit einer Verbindungsanordnung (100) zwischen einer aktiven Oberfläche (110) einer Elektrische Komponente (101) und einem Träger (102), wobei auf der aktiven Oberfläche (110) und/oder auf dem Träger (102) elektrische Verbindungselemente (103) in einer Verbindungszone (112) angeordnet sind, sowie mindestens ein Abstandselement (109) vorgesehen ist, das auf der aktiven Oberfläche (110) und/oder auf dem Träger (102) angeordnet ist. Das mindestens eine Abstandselement (109) weist eine geringere Höhe (H_109) auf als die Verbindungselemente (103) vor einem Aufschmelzen der Verbindungselemente (103) zum Herstellen der elektrisch leitenden Verbindung und ist vorzugsweise in einem Randbereich (107, 108) der Verbindungszone (112) angeordnet.

## Beschreibung

Die Erfindung betrifft ein elektrisches Bauelement oder eine elektrische Baugruppe wie zum Beispiel ein Multichipmodul mit einer elektrischen Verbindungsanordnung und ein Verfahren zu dessen Herstellung nach den Oberbegriffen der unabhängigen Ansprüche.

Bauelemente mit oberflächenmontierten elektrischen Komponenten umfassen üblicherweise einen Träger, beispielsweise eine Leiterplatte, sowie ein oder mehrere ungehäuste elektrische Komponenten, wie z.B. Chips oder elektrische Einheiten, die auf dem Träger angeordnet und mit elektrischen Leitern des Trägers elektrisch verbunden sind. Um kleinere Abmessungen zu erreichen, kommen z.B. drahtlose Kontaktierungen wie Oberflächenmontage zum Einsatz. Bei derartigen SMD-Bauelementen (SMD = Surface Mounted Device) stellen nicht Bonddrähte die elektrische Verbindung zwischen Kontaktflächen der elektrischen Komponente und korrespondierenden elektrischen Anschlussfeldern des Trägers her, sondern die elektrische Verbindung wird zwischen der elektrischen Komponente und dem Träger durch eine gelötete Verbindung über Lotballen ("Bumps") zwischen Kontaktfeld auf der elektrischen Komponente und korrespondierendem Anschlussfeld auf dem Träger erzielt.

Bekannte Bauelemente ohne Bonddrähte sind beispielsweise so genannte Flip-Chips, bei denen der Chip unmittelbar mit der aktiven Kontaktierungsseite zum Träger hin montiert wird. Dadurch können besonders geringe Abmessungen und kurze Leiterlängen durch die Verwendung elektrisch leitfähiger Bumps erreicht werden. Bei sehr komplexen Schaltkreisen bietet diese Technologie oft die einzige sinnvolle Verbindungsmöglichkeit, mit der beispielsweise mehrere tausend Kontakte realisiert werden können, wobei die Herstellung der elektrischen Verbindung über alle Kontakte gleichzeitig erfolgt. Vorteilhaft kann die gesamte Fläche des Chips zur Kontaktierung genutzt werden. Um die elektrische Verbindung über die Bumps dauerhaft herzustellen, werden verschiedene Prozesse, wie beispielsweise Löten, leitfähiges Kleben, Pressschweißen und dergleichen angewendet.

Ein Problem bei derartigen Bauelementen ist das Einstellen eines definierten Abstands zwischen der oberflächenmontierten elektrischen Komponente und dem Träger.

Aus der WO 2008/073432 A2 ist ein Umschmelzlötverfahren bekannt, bei dem ein Halterelement mit Lot eingesetzt wird, um eine elektrische Komponente auf einen Träger zu pressen. Hierzu wird ein Füllmittel des Typs no-flow underfill eingesetzt, welches Abstandshalter enthält, die einen definierten Abstand zwischen der elektrischen Komponente und dem Träger ermöglichen.

Aus der US 2007/0181992 A1 ist ein Verfahren zum Verbinden zweier Chips bekannt, bei dem Lotballen (Bumps) und ein Füllmittel auf den einen Chip aufgetragen werden. Dem Füllmittel sind Abstandselemente beigemischt, um einen Sollabstand zwischen den Chips sicherzustellen, wenn die Lotballen zur Herstellung der elektrischen Verbindung aufgeschmolzen werden. Das Füllmittel kann ein sogenanntes "no-flow underfill" sein. Dazu sind die Abstandshalter in einer fließfähigen Matrix eingebettet, die lokal oder großflächig appliziert sein kann.

Die US 2007/0235217 A1 offenbart ein Verfahren, bei dem Polymer-Abstandshalter auf der Trägeroberfläche und/oder auf der Oberfläche der elektrischen Komponente aufgebracht werden, welche den Mindestabstand beim Verbinden der oberflächenmontierten elektrischen Komponente und dem Träger sicherstellen. Die elektrische Komponente wird mit ihren auf den Kontaktfeldern angeordneten Lotballen positionsgenau auf die Anschlussfeldern des Trägers aufgesetzt, wobei der Zwischenraum mit einem Füllmittel, insbesondere einem no-flow underfill, gefüllt sein kann Die Anordnung wird erwärmt, bis die Lotbumps aufgeschmolzen werden und sich eine metallische Verbindung zwischen den Kontaktfeldern der elektrischen Komponente und den Anschlussfeldern des Trägers ausbildet. Dabei wird ein Sollabstand durch die Abstandshalter eingestellt.

Bei Bauelementen mit sehr kleinen Lotbumps, beispielsweise unterhalb von 100 µm Durchmessern, besteht jedoch das Problem, dass die elektrische Komponente auf dem Füllmittel aufschwimmen kann oder, bei zu großer Anpresskraft beim Verbinden, der Abstand zwischen der elektrischen Komponente und dem Träger durch seitliche Verdrängung des Füllmittels zu klein wird, so dass die Zuverlässigkeit des Aufbaus leidet oder sogar Kurzschlüsse zwischen benachbarten Lotballen auftreten können.

Der Erfindung liegt die Aufgabe zugrunde, ein Verfahren anzugeben, bei dem ein Aufschwimmen der elektrischen Komponente auf dem Füllmittel vermieden werden kann. Weiterhin soll eine Verbindungsanordnung insbesondere mit kleinen Lotballen angegeben werden, welche eine verbesserte Zuverlässigkeit aufweist.

Die Aufgabe wird erfindungsgemäß durch die Merkmale der unabhängigen Ansprüche gelöst. Günstige Ausgestaltungen und Vorteile der Erfindung ergeben sich aus den weiteren Ansprüchen und der Beschreibung.

Es wird ein elektrisches Bauteil vorgeschlagen mit einer Verbindungsanordnung zwischen einer aktiven Oberfläche einer elektrischen Komponente und einem Träger, wobei auf der aktiven Oberfläche und/oder auf dem Träger elektrische Verbindungselemente in einer Verbindungszone angeordnet sind, sowie mindestens ein Abstandselement vorgesehen ist, das auf der aktiven Oberfläche und/oder auf dem Träger angeordnet ist. Das mindestens eine Abstandselement weist eine geringere Höhe auf, insbesondere eine signifikant geringere Höhe, als die Verbindungselemente vor einem Aufschmelzen der Verbindungselemente zum Herstellen der elektrisch leitenden Verbindung, und das mindestens eine Abstandselement ist in einem Randbereich der Verbindungszone angeordnet.

Besonders vorteilhaft kann das mindestens eine Abstandselement in einer Ecke des Verbindungsbereichs angeordnet sein, wenn dieses einen eckigen Querschnitt aufweist. Vorteilhaft sind in allen Ecken des Verbindungsbereichs Abstandselemente angeordnet. Insbesondere können Lotballen in den Ecken durch je ein Abstandselement ersetzt sein. Das Abstandselement kann metallisch leitend ausgebildet sein. In einer günstigen Ausgestaltung können Verbindungselemente und/oder Abstandselemente jeweils aus einem Weichlot gebildet sein, wobei das Lot der Abstandselemente einen höheren Schmelzpunkt besitzt als das Lot der Verbindungselemente.

Zweckmäßigerweise weist das mindestens eine Abstandselement eine höhere Schmelztemperatur auf als die elektrischen Verbindungselemente, so dass im Fügeprozess von elektrischer Komponente und Träger ein stabiler Mindestabstand eingehalten werden kann.

Insbesondere können die elektrischen Verbindungselemente aus Lot geformte Ballen sein, die mit üblichen Verfahren auf den Träger und/oder die elektrische Komponente aufgebracht werden können, etwa durch Beballen mittels dem so genannten Gang-Ball-Placement, der C4NP-Technik (C4NP = Controlled Collapse Chip Connection New Process), Lotpastendruck, Umschmelzen der Lotpaste und dergleichen.

Die aktive Oberfläche der elektrischen Komponente ist insbesondere als die Oberfläche zu verstehen, auf welcher Kontaktflächen zur elektrischen Kontaktierung der elektrischen Komponente von außen vorgesehen sind. Als elektrische Komponente ist bevorzugt eine Komponente zu verstehen, welche wenigstens eine elektrische Struktur aufweist, etwa eine Leiterbahn oder einen elektronischen Schaltkreis. Insbesondere umfasst die elektrische Komponente ein Substrat, auf dem ein oder mehrere solcher Strukturen ausgebildet sind.

Das elektrische Bauteil kann unterschiedlichste Elemente umfassen, wie etwa Flip-Chips, Aufbauten im Chip-Maßstab, Dioden, Spulen, Kondensatoren, Widerstände, Varistoren, optoelektronische Bauelemente und dergleichen.

Unter Verbindungsbereich ist insbesondere der Bereich zu verstehen, in dem Kontaktflächen auf der aktiven Oberfläche der elektrischen Komponente bzw. Anschlussfeldern des Trägers miteinander verbunden werden sollen.

Unter Randbereich ist insbesondere ein Gebiet des Verbindungsbereichs zu verstehen, welches außerhalb der Mitte des Verbindungsbereichs angeordnet ist.

Gemäß einer günstigen Ausgestaltung der Erfindung kann das mindestens eine Abstandselement eine wenigstens um 10% geringere Höhe, bevorzugt eine wenigstens 20% geringere Höhe, besonders bevorzugt eine wenigstens um 50% geringere Höhe aufweisen als die Verbindungselemente vor einem Aufschmelzen der Verbindungselemente zum Herstellen der elektrisch leitenden Verbindung. Vorteilhaft kann ein ausreichender Druck auf ein Füllmittel ausgeübt werden, um dieses möglichst gleichmäßig in der Verbindungszone zu verteilen.

Gemäß einer günstigen Ausgestaltung der Erfindung kann das mindestens eine Abstandselement ein Lotmaterial und/oder ein Polymer umfassen. In der Ausgestaltung als Lotmaterial kann eine elektrische Verbindung über das Abstandselement hergestellt werden. In der Ausgestaltung als Polymer kann das Abstandselement eine elektrische Isolation bewirken oder in Verbindung mit Elektroden auf den Verbindungspartnern eine Kapazität aufweisen, also einen Kondensator realisieren.

Gemäß einer günstigen Ausgestaltung der Erfindung kann das mindestens eine Abstandselement eine Höhe von höchstens 50 µm, bevorzugt von höchstens 40 µm, besonders bevorzugt von höchstens 35 µm, aufweisen. Vorteilhaft kann der Durchmesser der elektrischen Verbindungselemente vor dem Aufschmelzen des Lotes etwa die doppelte Größe aufweisen als die Höhe des mindestens einen Abstandselements. Insbesondere weisen die elektrischen Verbindungselemente einen Durchmesser von höchstens 100 µm, bevorzugt von höchstens 80 µm, besonders bevorzugt von höchstens 70 µm, ganz besonders bevorzugt von höchstens 60 µm auf.

Gemäß einer günstigen Ausgestaltung der Erfindung kann das mindestens eine Abstandselement und die elektrischen Verbindungselemente in einem, insbesondere nichtfließenden, Füllmittel eingebettet sein. Das Füllmittel des Typs "no-flow underfill" dient vorteilhaft zum Schutz des Zwischenraums zwischen der elektrischen Komponente und dem Träger und kann diese hermetisch versiegeln. Dadurch kann das Bauelement beispielsweise in feuchter oder flüssiger Umgebung eingesetzt werden. Außerdem verbessert sich die Temperaturwechselfestigkeit des Aufbaus. Zusätzlich kann das Bauelement auch eine äußere Kapselung aufweisen, welches mit einem Polymer, z. B. Epoxidharz mit Siliziumdioxid-, Aluminiumoxid-, oder/und Aluminiumnitridpartikeln oder einem Material mit ähnlichen Werkstoffeigenschaften versehen oder gefüllt ist.

Gemäß einer günstigen Ausgestaltung der Erfindung können die elektrischen Verbindungselemente aus einem Zinn-Silber-Kupfer-Lot gebildet sein. Vorteilhaft kann das mindestens eine Abstandselement aus einem eutektischen Gold-Zinn-Lot gebildet sein. Der Schmelzpunkt des eutektischen Gold-Zinn-Lots liegt bei etwa 280°C und ist höher als der Schmelzpunkt des Zinn-Silber-Kupfer-Lots, der bei etwa 220°C liegt.

Gemäß einem weiteren Aspekt der Erfindung wird ein Verfahren zur Herstellung eines elektrischen Bauteils vorgeschlagen mit einer elektrischen Verbindungsanordnung zwischen einer aktiven Oberfläche einer elektrischen Komponente und einem Träger, mit den Verfahrensschritten
- Bereitstellen der elektrische Komponente und des Trägers, wobei die aktive Oberfläche und/oder der Träger mit einer Mehrzahl von elektrischen Verbindungselementen und wenigstens einem Abstandselement versehen sind;
- Aufbringen eines Füllmittels auf dem Träger und/oder der aktiven Oberfläche im Bereich der elektrischen Verbindungselemente und des wenigstens einen Abstandselements;
- Zusammenfügen der elektrischen Komponente und des Trägers;
- Aktivieren des Füllmittels;
- Aufschmelzen der Verbindungselemente;
- Aufsetzen des wenigstens einen Abstandselements auf seiner vorgesehenen Kontaktfläche.
- Aushärten des Füllmittels und/oder der elektrischen Verbindungselemente.

Vorteilhaft kann auch bei kleinen Abmessungen der elektrischen Verbindungselemente ein Aufschwimmen der elektrischen Komponente auf dem Füllmittel vermieden werden.

Gemäß einer günstigen Ausgestaltung kann das Füllmittel dosiert ins Zentrum der Verbindungszone aufgebracht werden. Insbesondere kann das Füllmittel so aufgebracht werden, dass dieses beim Aufbringen im Zentrum dicker ist und nach außen in der Dicke abnimmt. Dabei kann die Menge so dosiert sein, dass ein Ausfüllen des gewünschten Zwischenraums zwischen der elektrischen Komponente und dem Träger zuverlässig erfolgen kann. Gemäß einer günstigen Ausgestaltung kann beim Zusammenführen der elektrischen Komponente und des Trägers ein Anpressdruck ausgeübt werden, so dass sich das Füllmittel unterhalb der elektrischen Komponente verteilen kann.

Gemäß einer günstigen Ausgestaltung kann vor dem Bereitstellen der elektrischen Komponente und des Trägers beim Aufbringen der elektrischen Verbindungselemente simultan eine oder mehrere Leerstellen für das mindestens eine Abstandselement vorgesehen werden. Vorteilhaft können beim simultanen Aufbringen der elektrischen Verbindungselemente auf den Träger und/oder die aktiven Oberfläche ein oder mehrere Lotballen ausgelassen werden, vorteilhafterweise Eck-Lotballen oder Lotballen in der Nähe von Ecken der mit Lotballen zu versehenden Fläche. Anschließend kann ein oder mehrere Abstandselemente auf die Leerstellen aufgebracht werden, etwa mittels Lot-Aufspritzen ("Solder Jetting"), indem entweder eine Lotkugel über eine Kapillare zugeführt und mittels Laserstrahl aufgeschmolzen wird oder flüssiges Lot aus einem Vorratsbehälter durch eine Kanüle ausgestoßen wird, Lotballen-Auftrag ("Solder-Sphere placement") oder dergleichen. Zusätzlich oder alternativ kann das mindestens eine Abstandselement jedoch auch an jeder beliebigen Position im Verbindungsbereich angeordnet sein.

Gemäß einer günstigen Ausgestaltung kann das Zusammenführen der elektrischen Komponente und des Trägers bei einer erhöhten Temperatur zwischen 30°C und 80°C erfolgen. Zweckmäßigerweise kann ein hoher Anpressdruck ausgeübt werden, so dass sich das Füllmittel möglichst gleichmäßig unterhalb der elektrischen Komponente verteilen kann und die elektrischen Verbindungselemente auf ihren vorgesehenen Kontaktflächen aufsitzen. Die Temperatur kann weiter erhöht werden, bis die elektrischen Verbindungselemente aufschmelzen und die elektrische Komponenten nunmehr auf dem mindestens einen Abstandselement, beispielsweise auf den Abstandselementen in den Eckpositionen aufsitzt und das Füllmittel bis zu den Rändern des Verbindungsbereichs verdrängt wird.

Gemäß einer günstigen Ausgestaltung kann das Füllmittel thermisch aktiviert werden. Zweckmäßigerweise wird eine Temperatur angewendet, bei der ein im Füllmittel enthaltenes Flussmittel aktiv wird und unerwünschte etwaige Metalloxide von den Kontaktflächen der elektrischen Komponente und den Anschlussfeldern des Trägers entfernt, so dass eine niederohmige elektrische Verbindung hergestellt werden kann. Denkbar sind auch andere Aktivierungstechniken, etwa mittels UV-Bestrahlung und dergleichen.

Gemäß einer günstigen Ausgestaltung kann das Füllmittel bei erhöhter Temperatur und Anpressdruck ausgehärtet werden. Damit kann die gefügte Anordnung stabilisiert werden.

Gemäß einer günstigen Ausgestaltung können die elektrischen Verbindungselemente bei erhöhter Temperatur und wirkendem Anpressdruck ausgehärtet werden. Damit kann die gefügte Anordnung stabilisiert werden.

Die Erfindung ist insbesondere für ein elektrisches Bauelement geeignet, das als Implantat in einem menschlichen oder tierischen Körper vorgesehen ist.

Die Erfindung ist nachfolgend beispielhaft, anhand von einem in Zeichnungen dargestellten Ausführungsbeispiel, näher erläutert. Es zeigen in schematischer Darstellung:
- Fig. 1: ein Träger mit Anschlussfeldern zum Anschließen einer elektrischen Komponente;
- Fig. 2: ein Träger mit Anschlussfeldern, wobei auf einigen Anschlussfeldern Abstandselemente angeordnet sind;
- Fig. 3: der Träger aus Fig. 1, auf dem ein Füllmittel über einem Verbindungsbereich mit Anschlussfeldern aufgebracht ist;
- Fig. 4: der Träger aus Fig. 3, über dem eine elektrische Komponente mit Lotballen und Abstandselementen positioniert ist;
- Fig. 5: ein Aufbau aus Träger und elektrischer Komponente aus Fig. 4 beim Aufschmelzen der Lotballen; und
- Fig. 6: der Aufbau aus Fig. 5 mit ausgehärtetem Füllmittel.

In den Figuren sind funktionell gleiche oder gleich wirkende Elemente jeweils mit denselben Bezugszeichen beziffert. Die Figuren sind schematische Darstellungen der Erfindung. Sie bilden nicht spezifische Parameter der Erfindung ab. Weiterhin geben die Figuren lediglich typischen Ausgestaltungen der Erfindung wieder und sollen die Erfindung nicht auf die dargestellten Ausgestaltungen beschränken.

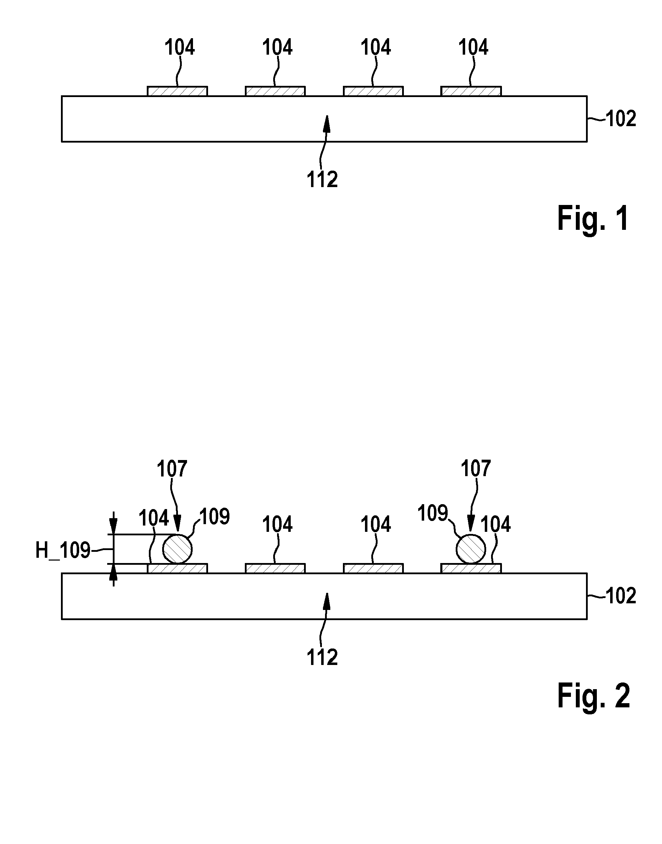

Die Figuren 1 bis 6 illustrieren verschiedene Verfahrensschritte einer vorteilhaften Ausführung eines erfindungsgemäßen Verfahrens zur Herstellung eines elektrischen Bauteils.

Das elektrische Bauteil umfasst eine Verbindungsanordnung 100 zwischen einer aktiven Oberfläche 110 einer elektrischen Komponente 101, beispielsweise eines Halbleiter-Chips, und einem Träger 102.

Fig. 1 zeigt den Träger 102, etwa eine Platine mit gedruckten Schaltungen, mit Anschlussfeldern 104 auf seiner Oberfläche, die in einem Verbindungsbereich 112 angeordnet sind. Fig. 2 zeigt eine Variante, bei dem auf Anschlussfeldern 104 im Randbereich des Verbindungsbereichs 112 des Trägers 102 Abstandselemente 109 mit einer Höhe H_109 angeordnet sind.

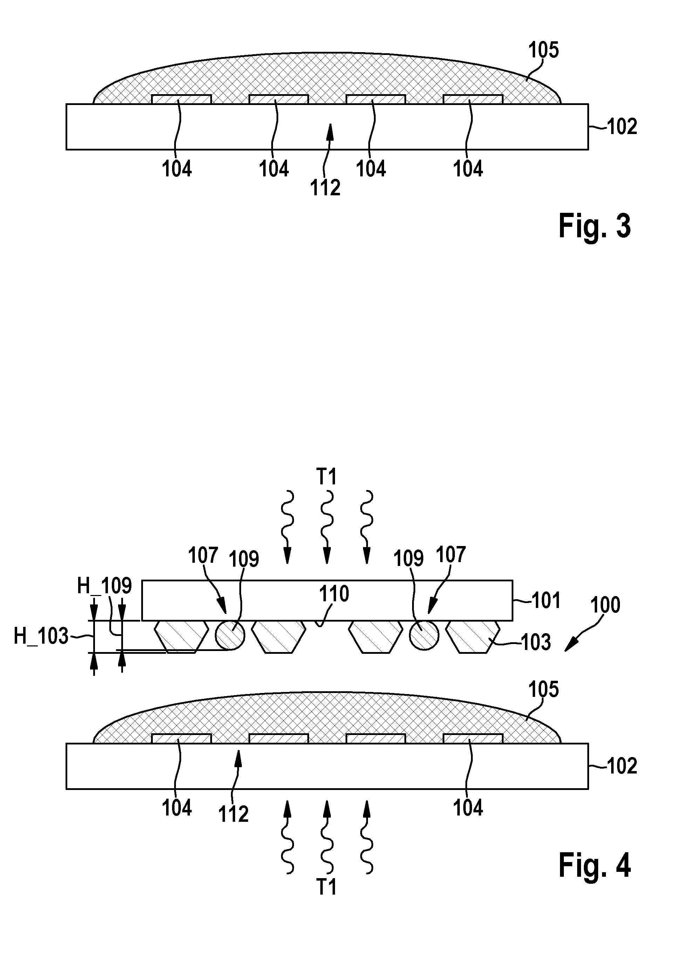

Fig. 3 zeigt den Träger aus Figur 1, wobei in der Mitte des Verbindungsbereichs 112 ein Füllmittel 105 dosiert aufgetragen ist. Das Füllmittel 105 ist in der Mitte dicker als an seinem Randbereich und überdeckt die Anschlussfeldern 104. Das Füllmittel 105 kann insbesondere eines vom Typ "no-flow underfill" sein. Ein no-flow underfill Füllmittel 105 ist ein Polymer mit einer bei erhöhter Temperatur als Flussmittel, also auf Metalloxide reduzierend wirkenden Komponente oder mehreren derartigen Bestandteilen. Das no-flow underfill Material enthält Teilchen aus Siliziumdioxid, Aluminiumoxid, Bornitrid, Berylliumoxid oder Aluminiumnitrid mit einer Teilchengröße von 0,1 bis 10 µm.

Fig. 4 zeigt eine bereitgestellte elektrische Komponente 101, beispielsweise einen mikroelektronischen Halbleiterchip, deren aktive Oberfläche 110 dem Träger 102 zugewandt ist. Die aktive Oberfläche 110 weist elektrische Verbindungselemente 103 auf, beispielsweise Lotballen, die auf nicht näher bezeichneten Kontaktfeldern auf der aktiven Oberfläche 110 angeordnet sind und deren Position jeweils mit den Anschlussfeldern 104 des Trägers korrespondiert.

Inmitten der elektrischen Verbindungselemente 103 sind Abstandselemente 109 angeordnet, beispielsweise im Randbereich 107 der elektrischen Komponente 101, deren Höhe H_109 signifikant geringer ist als die Höhe H_103 der elektrischen Verbindungselemente 103 vor einem Aufschmelzen der Verbindungselemente 103 zum Herstellen der elektrisch leitenden Verbindung. Die Höhe H_109 der Abstandselemente 109 ist vorzugsweise wenigstens 10% geringer, besonders bevorzugt wenigstens 20% geringer und weiter bevorzugt mindestens 50% geringer.

Die Lotballen (Verbindungselemente 103) können beispielsweise aus bleifreiem Lot, bevorzugt Zinn-Silber-Kupfer-Lot, beispielsweise SAC305-Lot, gebildet sein und weisen eine im Rahmen der Herstelltoleranzen einheitliche Größe auf. Die Lotballen können beispielsweise als kleine Lotkugeln mit etwa 60 µm Durchmesser mittels Gang-Ball Placement simultan auf den Kontaktfeldern der aktiven Oberfläche 110 abgelegt und auf diese aufgelötet sein. Beim simultanen Aufbringen der Verbindungselemente 103, die typischerweise matrixartig auf der aktiven Oberfläche 110 verteilt sind, können gezielt Leerstellen für Abstandselemente 109 freigelassen werden. In ecknahen Randbereichen 107 der elektrischen Komponente 101 sind einige einzelne Abstandselemente 109 verteilt, die beispielsweise aus kleinen Lotkugeln aus einem Au80Sn20-Lot mittels Selective Solder-Jetting. Diese Lotkugeln weisen einen kleineren Durchmesser auf, beispielsweise nur etwa 40 µm.

Die Abstandselemente 109 können bevorzugt in einem sequentiellen Verfahren aufgebracht werden, beispielsweise durch Solder-Jetting, bei dem eine Lotkugel durch eine Kapillare befördert und durch einen Laserstrahl bzw. Ausstoß von flüssigem Lot in einem Vorratsbehälter durch eine Kapillare oder aber auch simultan vor oder vorzugsweise nach den Verbindungselementen 103 aufgeschmolzen wird.

Selbstverständlich können die elektrischen Verbindungselemente 103 und/oder die Abstandselemente 109 ganz oder teilweise auch auf dem Träger 102 angeordnet sein, wie in Fig. 2 für die Abstandselemente 109 gezeigt wurde.

In Fig. 4 ist dargestellt, dass die elektronische Komponente 101 präzise so platziert wird, dass die elektrischen Verbindungselemente 103 genau über den vorgesehenen Anschlussfeldern 104 angeordnet sind.

In diesem Verfahrensstadium kann der Träger 102 und die elektrische Komponente 101 auf eine erste Temperatur T1 aufgeheizt werden. Die Temperatur T1 liegt günstigerweise in einem Bereich von 30°C bis 80°C.

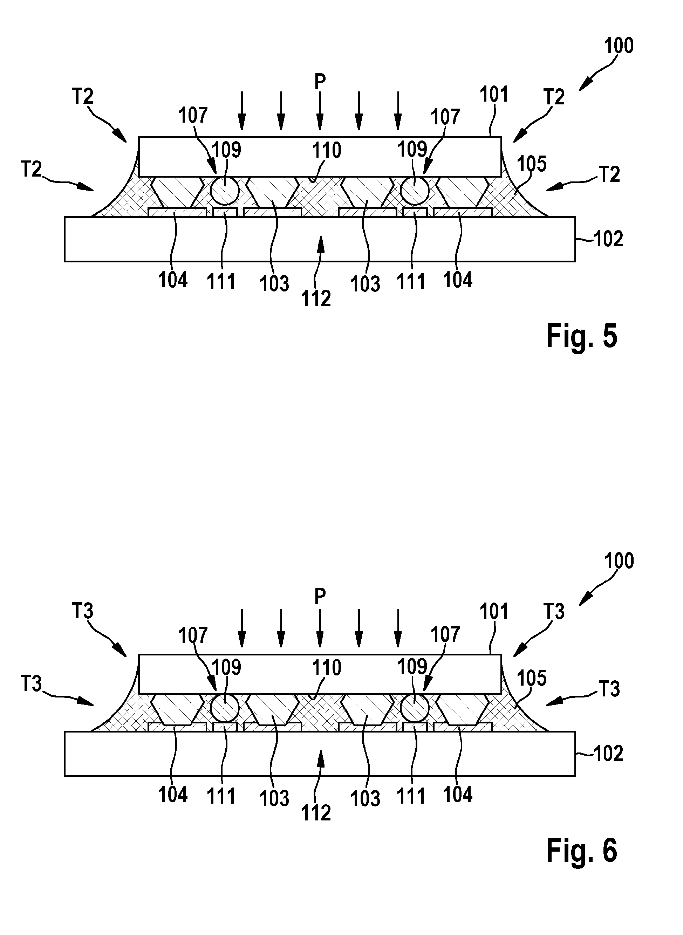

Die elektrische Komponente 101 wird mit den elektrischen Verbindungselementen 103 auf ihrer aktiven Oberfläche 110 und auf die Anschlussfelder 104 des Trägers 102 aufgesetzt (Fig. 5) und mit einem hohen Anpressdruck P gegen den Träger 102 gedrückt. Dabei wird das Füllmittel 105 nach außen gedrückt, so dass dieses sich in der Verbindungszone 112 relativ gleichmäßig verteilt. Die Abstandselemente 109 sind im Randbereich 107 der elektrischen Komponente 101 angeordnet und sind zu ihren vorgesehenen Kontaktflächen 111 wegen ihrer geringen Höhe H_109 noch mit einem Abstand versehen.

Die Temperatur wird soweit erhöht, dass ein im Füllmittel 105 enthaltenes Flussmittel aktiviert wird und etwaige Verunreinigungen wie Oxide von den Kontaktflächen und Anschlussfeldern 104 entfernt werden. Die Prozesstemperatur liegt hierbei zwischen 120°C und 190°C. Die Temperatur wird beispielsweise auf eine zweite Temperatur T2 erhöht, bei der die elektrischen Anschlusselemente 103 aufschmelzen und die Metallisierung der korrespondierenden Kontaktfelder 108 benetzen, so dass die elektrische Komponente 101 mit ihren Abstandselementen 109 auf den entsprechenden Kontaktflächen 111 des Trägers 102 aufsetzen und das Füllmittel 105 bis an die Kanten der elektrischen Komponente 101 herausgedrängt wird.

Unter Beibehaltung des Anpressdrucks P und einer erhöhten Temperatur T3 wird das Füllmittel 105 ausgehärtet. Anschließend wird die Anordnung unter dem Anpressdruck abgekühlt, so dass die elektrischen Verbindungselemente 103 erstarren, wie in Fig. 6 dargestellt ist. Die Temperatur T3 kann gleich der Temperatur T2 beim Aufschmelzen der elektrischen Verbindungselemente 103 sein, oder beispielsweise niedriger sein. Jedoch bleibt die Temperatur jeweils unterhalb der Schmelztemperatur der Abstandselemente 109.

Das mindestens eine Abstandselement 109 kann ein Lotmaterial, insbesondere ein eutektisches Gold-Zinn-Lot, und/oder ein Polymer, beispielsweise ein thermoplastisches Material oder LCP (Liquide Crystal Polymer), sein. Zweckmäßigerweise ist das Abstandselement 109 ein Weichlot, wenn es in einer Ausgestaltung als Lotmaterial vorgesehen ist. Die elektrischen Verbindungselemente 103 können aus einem Zinn-Silber-Kupfer-Lot, einem Zinn-Silber-Lot oder einem Zinn-Kupfer-Lot gebildet sein, dessen Schmelzpunkt unter dem des Schmelzpunkts der Abstandselemente 109 liegt.

Anschließend kann optional noch ein Material zur Kapselung der gesamten Anordnung aufgetragen werden.

## Patentansprüche

1. Elektrisches Bauteil oder elektrische Baugruppe mit einer Verbindungsanordnung (100) zwischen einer aktiven Oberfläche (110) einer elektrischen Komponente (101) und einem Träger (102), wobei auf der aktiven Oberfläche (110) und/oder auf dem Träger (102) elektrische Verbindungselemente (103) in einer Verbindungszone (112) angeordnet sind, sowie mindestens ein Abstandselement (109) vorgesehen ist, das auf der aktiven Oberfläche (110) und/oder auf dem Träger (102) angeordnet ist, **dadurch gekennzeichnet, dass** das mindestens eine Abstandselement (109) eine geringere Höhe (H_109) aufweist als die Verbindungselemente (103) vor einem Aufschmelzen der Verbindungselemente (103) zum Herstellen der elektrisch leitenden Verbindung und vorzugsweise in einem Randbereich (107, 108) der Verbindungszone (112) angeordnet ist.

2. Elektrisches Bauteil oder elektrische Baugruppe nach Anspruch 1, **dadurch gekennzeichnet, dass** das mindestens eine Abstandselement (109) eine wenigstens um 10% geringere Höhe (H_109) als die Verbindungselemente (103), bevorzugt eine wenigstens um 20% geringere Höhe (H_109), besonders bevorzugt eine um wenigstens 50% geringere Höhe (H_109) hat.

3. Elektrisches Bauteil oder elektrische Baugruppe nach einem der vorhergehenden Ansprüche, **dadurch gekennzeichnet, dass** das mindestens eine Abstandselement (109) ein Lotmaterial und/oder ein Polymer umfasst, vorzugsweise ein Lotmaterial aus einem eutektischen Gold-Zinn-Lot.

4. Elektrisches Bauteil oder elektrische Baugruppe nach einem der vorhergehenden Ansprüche, **dadurch gekennzeichnet, dass** das mindestens eine Abstandselement (109) eine Höhe (H_109) von höchstens 50 µm, bevorzugt von höchstens 40 µm, besonders bevorzugt von höchstens 35 µm, aufweist.

5. Elektrisches Bauteil oder elektrische Baugruppe nach einem der vorhergehenden Ansprüche, **dadurch gekennzeichnet, dass** das mindestens eine Abstandselement (109) und die elektrischen Verbindungselemente (103) in einem Füllmittel (105), insbesondere einem nichtfließenden Füllmittel (105), eingebettet sind.

6. Elektrisches Bauteil oder elektrische Baugruppe nach einem der vorhergehenden Ansprüche, **dadurch gekennzeichnet, dass** die elektrischen Verbindungselemente (103) aus einem Zinn-Silber-Kupfer-Lot gebildet sind und das mindestens eine Abstandselement (109) aus einem eutektischen Gold-Zinn-Lot gebildet ist.

7. Verfahren zur Herstellung eines elektrischen Bauteils oder einer elektrischen Baugruppe mit einer elektrischen Verbindungsanordnung (100) zwischen einer aktiven Oberfläche (110) einer elektrischen Komponente (101) und einem Träger (102), nach einem der vorhergehenden Ansprüche, **gekennzeichnet durch**
- Bereitstellen der elektrischen Komponente (101) und des Trägers (102), wobei die aktive Oberfläche (110) und/oder der Träger (102) mit einer Mehrzahl von elektrischen Verbindungselementen (103) und mindestens einem Abstandselement (109) beschichtet sind, wobei das mindestens eine Abstandselement (109) eine geringere Höhe (H_109) aufweist als die elektrischen Verbindungselemente (103) und in einem Randbereich (107, 108) einer Verbindungszone (112) angeordnet ist;
- Aufbringen eines Füllmittels (105) auf dem Träger (102) und/oder der aktiven Oberfläche (110) in einem Verbindungsbereich (112) der elektrischen Verbindungselemente (103) und des wenigstens einen Abstandselements (109);
- Zusammenfügen der elektrischen Komponente (101) und des Trägers (102);
- Aktivieren des Füllmittels (105), so dass es reduzierend auf Metalloxide wirkt;
- Aufschmelzen der Verbindungselemente (103);
- Aufsetzen des wenigstens einen Abstandselements (109) auf seiner vorgesehenen Kontaktfläche (111).
- Aushärten des Füllmittels (105) und/oder Erstarren der elektrischen Verbindungselemente (103).

8. Verfahren nach Anspruch 7, **dadurch gekennzeichnet, dass** das Füllmittel (105) dosiert ins Zentrum der Verbindungszone (112) aufgebracht wird.

9. Verfahren nach Anspruch 7 oder 8, **dadurch gekennzeichnet, dass** beim Zusammenführen der elektrischen Komponente (101) und des Trägers (102) ein Anpressdruck (P) ausgeübt wird, so dass sich das Füllmittel (105) unterhalb der elektrischen Komponente (101) verteilt.

10. Verfahren nach einem der Ansprüche 7 bis 9, **dadurch gekennzeichnet, dass** vor dem Bereitstellen der elektrischen Komponente (101) und des Trägers (102) beim Aufbringen der elektrischen Verbindungselemente (103) simultan eine oder mehrere Leerstellen für das mindestens eine Abstandselement (109) vorgesehen werden.

11. Verfahren nach einem der Ansprüche 7 bis 10, **dadurch gekennzeichnet, dass** das Zusammenführen der elektrischen Komponente (101) und des Trägers (102) bei einer erhöhten Temperatur (T1) oberhalb von 30°C erfolgt.

12. Verfahren nach einem der Ansprüche 7 bis 11, **dadurch gekennzeichnet, dass** das Füllmittel (105) thermisch aktiviert wird.

13. Verfahren nach einem der Ansprüche 7 bis 12, **dadurch gekennzeichnet, dass** das Füllmittel (105) bei erhöhter Temperatur (T2, T3) und wirkendem Anpressdruck (P) ausgehärtet wird.

14. Verfahren nach einem der Ansprüche 7 bis 13, **dadurch gekennzeichnet, dass** die elektrischen Verbindungselemente (103) bei erhöhter Temperatur (T2, T3) und wirkendem Anpressdruck (P) ausgehärtet werden.

15. Verfahren nach einem der Ansprüche 7 bis 14, **dadurch gekennzeichnet, dass** das mindestens eine Abstandselement (109) durch Solder-Jetting aufgebracht wird.
